# EUROPÄISCHE PATENTANMELDUNG

(11) **EP 0 681 306 A1**
(43) Veröffentlichungstag der Anmeldung: **08.11.1995**
(21) Anmeldenummer: 95106852.7
(22) Anmeldetag: 05.05.1995
(51) Int. Cl.: H01G 2/08

(54) **Elektrisches Bauelement**

(30) Priorität: 05.05.1994 DE 4415950
(71) Anmelder: SIEMENS MATSUSHITA COMPONENTS GmbH & CO KG, D-81617 München (DE)
(72) Erfinder: Grimm, Wilhelm, Dipl. Ing., D-91154 Roth (DE); Sperlich, Reinhard, Dipl. Ing., D-83059 Kolbermoor (DE)
(74) Vertreter: Fuchs, Franz-Josef, Dr.-Ing.

(57) **Zusammenfassung**

Bei einem elektrischen Bauelement(7), das Werkstoffe enthält, die sich unter Einwirkung von bei einer weiteren Verarbeitung erforderlichen Wärme(IR)-Bestrahlung physikalisch und/oder chemisch verändern können, und das insbesondere zum Einsatz auf gedruckten Schaltungen geeignet ist,ist auf der Außenseite des Bauelements (7) eine die Wärme(IR)-Strahlung reflektierende Oberflächenschicht (22) angeordnet .

## Beschreibung

Die Erfindung betrifft ein elektrisches Bauelement, das Werkstoffe enthält, die sich unter Einwirkung von bei einer weiteren Verarbeitung erforderlichen Wärme(IR)-Bestrahlung physikalisch und/oder chemisch verändern können, und das insbesondere zum Einsatz auf gedruckten Schaltungen geeignet ist.

Das Befestigen von elektrischen Bauelementen auf Leiterplatten erfolgt beispielsweise durch eine Reflowlötung. Hierbei wird die Leiterplatte mit den darauf angeordneten Bauelementen durch IR-Strahlung soweit erwärmt, bis das Lot schmilzt und die erforderliche sichere elektrische und mechanische Verbindung zwischen den Bauelementen und den metallischen Leiterbahnen herstellt. Bei Bauelementen mit wärmeempfindlichen Werkstoffen, z.B. elektrischen Kondensatoren mit Kunststoffolien, ist deswegen besondere Vorsicht notwendig, um die Werkstoffe durch die mittels der IR-Strahlung hervorgerufene Erwärmung nicht zu schädigen oder zu verändern. Beispielsweise besteht die Gefahr, daß bei den genannten Kondensatoren die Kunststoffolien (z.B.aus Polyethylenterephthalat) unter der Wärmeeinwirkung anschmelzen, so daß der Kondensator in seinen elektrischen Werten verändert wird.

Eine weitere Wärmebehandlung mittels IR-Strahlung besteht in sogenannten Vorwärmstrecken (Fluxmittel-Trockenstrecken) bei der die vorstehend angeführten Gefahren für elektrische Bauelemente ebenfalls auftreten können.

Die aufgezeigten Schwierigkeiten bei der Wärmebehandlung elektrischer Bauelemente mittels IR-Strahlung versucht man bis jetzt dadurch zu minimieren, daß die vom Hersteller vorgegebenen Maximaltemperaturen und -behandlungszeiten korrekt eingehalten werden. Die Gefahr besteht jedoch darin, daß genaue Voraussagen über Erwärmung von Bauelementen durch IR-Bestrahlung nur schwer zu machen sind, da die Erwärmung von vielen Parametern (z.B.Abstand, Wellenlänge und Energie der Strahlung, Reflexion und Absorption beim Bauelement usw.) abhängt, so daß Unter ungünstigen Umständen selbst bei größtmöglicher Vorsicht Schädigungen des Bauelements nicht auszuschließen sind.

Aufgabe der vorliegenden Erfindung ist es daher, das eingangs genannte Bauelement derart zu verbessern, daß die unerwünschte Erwärmung durch IR-Strahlung vermindert wird.

Diese Aufgabe wird erfindungsgemäß dadurch gelöst, daß auf der Außenseite des Bauelements eine die Wärme(IR)-Strahlung reflektierende Oberflächenschicht angeordnet ist.

Hierdurch wird der Vorteil erziehlt, daß eine Absorption der IR-Strahlung im Bauelement weitestgehend vermieden und damit die nicht gewünschte Erwärmung verhindert wird.

Die reflektierende Schicht besteht vorteilhafterweise aus einer Metallisierung, die auf einer Kunststoffolie oder direkt auf dem Bauelement angeordnet ist(z.B.aus Aluminium) bzw.aus einer Metallfolie.

Das elektrische Bauelement ist vorzugsweise als Schicht- bzw. Stapelkondensator oder aber als gegebenenfalls flachgedrückter Wickelkondensator ausgebildet

Das elektrische Bauelement kann an seinen Stirnseiten Kontaktflächen besitzen, die nach dem Schoop'schen Metallspritzverfahren hergestellt sind. Hierbei besitzt die reflektierende Schicht vorzugsweise zumindest auf einer Seite einen Freirand, der im Bereich einer Schoopschicht angeordnet ist.

Die Erfindung wird anhand der folgenden Ausführungsbeispiele erläutert.

In der dazugehörenden Zeichnung zeigen:
- Fig.1: einen Schicht- bzw. Stapelkondensator und
- Fig.2: einen Kondensator mit einem flachgepreßten Wickel als Kondensatorkörper.

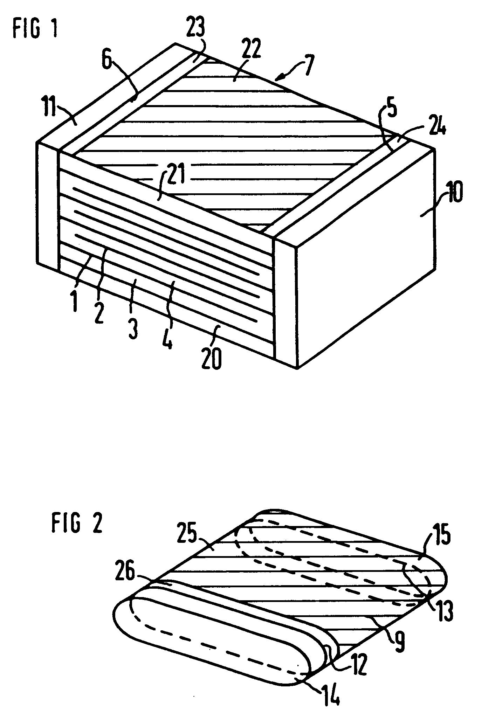

In Fig.1 ist ein Kondensatorkörper 7 als Stapel- bzw. Schichtkondensator dargestellt. Der Kondensatorkörper 7 besteht aus übereinander angeordneten Dielektrikumsfolien 3, 4, die wenigstens einseitig mit regenerierfähigen Metallschichten 1,2 versehen sind.

Auf den Stirnflachen 5,6 des Kondensatorkörpers 7 sind Kontaktschichten 10,11 angeordnet, die beispielsweise nach dem Schoop'schen Metallspritzverfahren hergestellt sind und dazu dienen, die alternierend an die Stirnflächen 5,6 reichenden Metallschichten 1,2 elektrisch miteinander zu verbinden.

Auf der Außenseite des Kondensatorkörpers 7 sind Kunststofffolien 20,21 angeordnet, die eine z.B. durch Aufdampfen hergestellte Oberflächenschicht 22 besitzen, welche Wärme(IR)-Strahlung reflektiert. Falls die Schicht 22 metallisch ist, sind an den Seiten metallfreie Randstreifen 23,24 angeordnet, die Kurzschlüsse zwischen den gegenpoligen Kontaktschichten 10,11 verhindern. Kurzschlüsse können gegebenenfalls auch durch Potentialtrennung in der Fläche 22 verhindert werden.

Die Kunststoffolien 20,21 mit den Oberflächenschichten 22 werden zweckmäßigerweise bei der Herstellung des Mutterkondensators auf den Wickel mitaufgewickelt.

In der Fig.2 ist eine weitere Ausführungsform dargestellt, bei der der Kondensatorkörper 9 aus einem flachgepreßten Wickel besteht.Auch in diesem Kondensator sind die in Fig.2 nicht sichtbaren regenerierfähigen Metallschichten auf Kunststoffolien aufgebracht und alternierend zu den Stirnflächen 12,13 geführt und dort durch die Kontaktschichten 14,15 miteinander verbunden.

Auf der Außenseite des Kondensatorkörpers 9 ist eine Wärme(IR)-Strahlung reflektierende Oberflächenschicht 25 angeordnet, die beispielsweise durch direkte Aufdampfung eines Metalls (z.B. Aluminium) auf den Kondensatorkörper 9 hergestellt ist. Um Kurzschlüsse zwischen den Kontaktschichten 14,15 zu vermeiden, ist ein metallfreier Randstreifen 26 parallel zur Kontaktschicht 14 angeordnet. Wie bei dem in Fig.1 dargestellten Ausführungsbeispiel können auch beim flachgepreßten Kondensatorkörper 9 Kurzschlüsse zwischen den Kontaktschichten 14,15 gegebenenfalls durch eine Potentialtrennung in der Fläche 25 verhindert werden.

Neben den in der Zeichnung dargestellten Ausführungen sind selbstverständlich auch andere Varianten von Oberflächenschichten möglich. So kann bei isolierender Abdeckung der Kontaktschichten die Oberflächenschicht auch eine gesamte Außenseite bedecken, da dann keine Kurzschlüsse entstehen können. Auch ist es möglich, die bei Schichtkondensatoren durch das Vereinzeln vom Mutterkondensator offenliegenden Seiten mit einer reflektierenden Schicht abzudecken. Allerdings sollte dabei berücksichtigt werden, daß der Hauptanteil der Wärmestrahlung von der der Leiterplatte abgewandten Außenfläche des Bauelements empfangen wird, so daß im Prinzip die Abdeckung dieser Fläche in den meisten Anwendungsfällen ausreichend ist. Da allerdings bei den modernen Bestückungsmethoden mit Maschinen eine Unterscheidung zwischen Ober- und Unterseite, d.h. der der Leiterplatte zu- bzw. abgewandten Außenseite nicht möglich ist, sollten zumindest diese beiden Seiten (in den Fig.1,2 die Ober- bzw. Unterseite) durch eine Oberflächenschicht geschützt sein.

Durch den Gegenstand der Erfindung wird somit gewährleistet, daß bei Behandlung von wärmeempfindlichen elektrischen Bauelementen mit IR-Bestrahlung eine weitestgehende Schonung der Bauelemente erreicht wird, so daß auch bei abweichenden Behandlungszeiten eine Zerstörung der Bauelemente vermieden wird.

## Patentansprüche

1. Elektrisches Bauelement, das Werkstoffe enthält, die sich unter Einwirkung von bei einer weiteren Verarbeitung erforderlichen Wärme(IR)-Bestrahlung physikalisch und/oder chemisch verändern können, und das insbesondere zum Einsatz auf gedruckten Schaltungen geeignet ist,
**dadurch gekennzeichnet,**
daß auf der Außenseite des Bauelements (7,9) eine die Wärme(IR)-Strahlung reflektierende Oberflächenschicht (22,25) angeordnet ist.

2. Elektrisches Bauelement nach Anspruch 1,
**dadurch gekennzeichnet,**
daß die reflektierende Schicht aus einer Metallisierung (22) besteht, die auf einer Kunststoffolie (21) angeordnet ist.

3. Elektrisches Bauelement nach Anspruch 1,
**dadurch gekennzeichnet,**
daß die reflektierende Schicht aus einer direkt auf das Bauelement (9) aufgebrachten Metallisierung (25) besteht.

4. Elektrisches Bauelement nach Anspruch 2 oder 3,
**dadurch gekennzeichnet,**
daß die Metallisierung (22,25) aus Aluminium besteht.

5. Elektrisches Bauelement nach Anspruch 1,
**dadurch gekennzeichnet,**
daß die reflektierende Schicht aus einer Metallfolie besteht.

6. Elektrisches Bauelement nach einem der Ansprüche 1 bis 5,
**dadurch gekennzeichnet,**
daß das elektrische Bauelement als Schicht- oder Stapelkondensator (7) ausgebildet ist.

7. Elektrisches Bauelement nach einem der Ansprüche 1 bis 5,
**dadurch gekennzeichnet,**
daß das elektrische Bauelement als Wickelkondensator (9) ausgebildet ist.

8. Elektrisches Bauelement nach Anspruch 7,
**dadurch gekennzeichnet,**
daß der Wickel (9) flachgedrückt ist.

9. Elektrisches Bauelement nach einem der Ansprüche 1 bis 8,
**dadurch gekennzeichnet,**
daß das elektrische Bauelement (7,9) an seinen Stirnseiten Kontaktflachen (10,11;14,15) besitzt, die nach dem Schoop'schen Metallspritzverfahren hergestellt sind.

10. Elektrisches Bauelement nach Anspruche 9,
**dadurch gekennzeichnet,**
daß die reflektierende Schicht (22,25) zumindest auf einer Seite einen Freirand (23,24,26)besitzt, der im Bereich einer Schoopschicht (10,11;14,15) angeordnet ist.
